# EUROPEAN PATENT SPECIFICATION

(11) **EP 1 454 393 B1**
(45) Date of publication and mention of the grant of the patent: **11.05.2005**
(21) Application number: 02787246.4
(22) Date of filing: 11.12.2002
(51) Int. Cl.: H01S 5/18, H01S 5/12

(54) **PHASE SHIFTED SURFACE EMITTING DFB LASER STRUCTURES WITH GAIN OR ABSORPTIVE GRATINGS**
PHASENVERSCHOBENE OBERFLÄCHENEMITTIERENDE DFB LASERSTRUKTUREN MIT VERSTÄRKENDEN ODER ABSORBIERENDEN GITTERN
STRUCTURES LASER A RESONATEUR DISTRIBUE, EMETTRICES PAR LA SURFACE, DEPHASEES, A RESEAUX A GAIN OU ABSORBANTS

(30) Priority: 11.12.2001 CA 2364817
(43) Date of publication of application: 08.09.2004
(73) Proprietor: Photonami Corporation, Ontario, L4B 1E4 (CA)
(72) Inventor: SHAMS-ZADEH-AMIRI, Ali, M., North York, Ontario M3A 1V4 (CA); LI, Wei, Plattville, Wisconsin 53818 (US)
(74) Representative: Frankland, Nigel Howard
(86) International application number: PCT/CA2002/001893
(87) International publication number: WO 2003/055019

(56) References cited:
- WO-A-01/13480
- WO-A-01/93385
- JP-A- 11 307 856
- JP-A- 2000 077 774
- US-A- 5 727 013
- US-A- 5 970 081
- US-A- 6 117 699
- US-B1- 6 330 268

## Description

### FIELD OF THE INVENTION

This invention relates generally to the field of telecommunications and in particular to optical signal based telecommunication systems. Most particularly, this invention relates to lasers, such as semiconductor diode lasers, for generating pump and carrier signals for such optical telecommunication systems.

### BACKGROUND OF THE INVENTION

Optical telecommunications systems are rapidly evolving and improving. In such systems individual optical carrier signals are generated, and then modulated to carry information. The individual signals are then multiplexed together to form dense wavelength division multiplexed (DWDM) signals. Improvements in optical technology have led to closer spacing of individual signal channels, such that it is now common for 40 signal channels to be simultaneously deployed in the C-band, with 80 or even 160 simultaneous signal channels in the combined C+L bands likely to be deployed in the near future.

Each signal channel requires an optical signal carrier source and in telecommunications the signal carrier source is typically a laser. As the number of DWDM signal channels increases, the number of signal carrier sources needed also increases. Further, as optical networks push outward from the data-dense long haul backbones to the data-light edge or end user connections, a vast number of new network nodes are needed, potentially each with the multiple signal carrier sources required for DWDM. As well, the cost of supplying signal carrier sources becomes an issue as a function of data traffic since the data density is less, the closer to edge of the network one is.

A number of different laser sources are currently available. These include various forms of fixed, switchable or tunable wavelength lasers, such as Fabry-Perot, Distributed Bragg Reflector (DBR), Vertical Cavity Surface Emitting Lasers (VCSEL) and Distributed Feedback (DFB) designs. Currently the most common form of signal carrier source used in telecommunication applications are edge emitting index coupled DFB laser sources, which have good performance in terms of modulation speed, output power, stability, noise and side mode suppression ratio (SMSR). In addition, by selecting an appropriate semiconductor material and laser design, communication wavelengths can be readily produced. In this sense SMSR refers to the property of DFB lasers to have two low threshold longitudinal modes having different wavelengths at which lasing can occur, of which one is typically desired and the other is not. SMSR comprises a measure of the degree to which the undesired mode is suppressed, thus causing more power to be diverted into the preferred mode, while also having the effect of reducing cross-talk from the undesired mode emitting power at the wavelength of another DWDM channel. A drawback of edge emitting DFB laser signal sources is that the beam shape is in the form of a stripe, strongly diverging in two dimensions with differing divergence angles due to the small aperture of the emitting area, which requires a spot converter to couple the signal to a single mode fibre. The necessary coupling techniques are difficult and can be lossy, resulting in increased cost.

Although they can achieve good performance once finished and coupled to the fibre, edge emitting DFB lasers have several fundamental characteristics that make them inefficient to produce and hence more expensive. More specifically, large numbers of edge emitting DFB lasers are currently produced simultaneously on a single wafer. However, the yield of viable edge emitting DFB lasers (i.e. those which meet the desired signal output specifications) obtained from a given wafer can be low due to a number of factors in the final fabrication or packaging steps. Specifically, once formed, the individual DFB laser must be cleaved off the wafer. The cleaving step is then followed by an end-finishing step, most usually the application of an anti-reflective coating to one end and a high-reflective coating to the other. The asymmetry introduced by different end coatings helps to give preference to one mode over the other, thus improving the SMSR. However, the single mode operation of the DFB laser is also a function of the phase of the grating where it was cleaved at the end of the laser cavity. Uncertainty in the phase introduced by the cleaving step results in low single mode yield due to poor SMSR. Multi-mode lasers produced in this way are not suitable for use in DWDM systems.

An important aspect of the fabrication of edge emitting DFB lasers is that the laser can only be tested by injecting a current into the lasing cavity after the laser has been completely finished, including cleaving from the wafer, end-coating. This compounds the inefficiency of such low yields from the wafer due to multi-mode behaviour or poor SMSR.

Both surface emission and single mode operation through complex coupling have been achieved by using a second or higher order grating instead of the more common first order grating. In the case of a second order grating, the resulting radiation loss from the surface of the laser is different for the two modes, thus lifting the degeneracy and resulting in single mode operation, as described by R. Kazarinov and C. H. Henry in IEEE, J. Quantum Electron., vol. QE-21, pp. 144-150, Feb. 1985. With an index coupled second order grating, the spatial profile of the preferred lasing mode is dual-lobed with a minimum at the centre of the laser cavity. The suppressed mode in this instance is a single-lobed Gaussian-like profile peaked at the centre of the cavity. This latter mode, while being beneficial to most applications, is perhaps even more critical in the field of telecommunications because it closely matches the mode shape of a single mode optical fibre and can therefore be efficiently coupled into the fibre. The dual-lobed shape can only be coupled to a fibre with poor efficiency.

Attempts have been made in the art to alter the laser such that the mode profile facilitates fibre coupling, but without much success. For example, US Patent 5,970,081 teaches a surface emitting, index coupled, second order grating DFB laser structure that introduces a phase shift into the laser cavity by means of constricting the shape of the wave guide cavity structure in the middle to improve the profile of the lasing mode and hence the coupling efficiency. However the phase shifted mode profile includes a steep peak which leads to a deterioration of other specifications related to an increase in spatial hole burning in the region of the phase shift. In addition the invention taught is difficult to implement due to the lithography involved. In US Patent 4,958,357 a laser is shown which includes an index coupled second order grating for surface emission which includes the use of a quarter-phase shift at the centre of the laser or a multiple phase shift within the laser cavity. This structure suffers from spatial hole burning as a result of the intense field generated in the region of the phase shift. This limits the output power of the device and is undesired.

Outside of the telecommunications field, an example of a surface emitting DFB laser structure is found in US Patent 5,727,013. This patent teaches a single lobed surface emitting DFB laser for producing blue/green light where the second order grating is written in an absorbing layer within the structure or directly in the gain layer. While interesting, this patent does not disclose how the grating affects fibre-coupling efficiency (since it is not concerned with any telecom applications). This patent also fails to teach what parameters control the balance between total output power and fibre coupling efficiency or how to effectively control the mode. Lastly, this patent fails to teach a surface emitting laser that is suitable for telecommunication wavelength ranges.

More recently, attempts have been made to introduce vertical cavity surface emitting lasers (VCSELs) with performance suitable for the telecommunications field. Such attempts have been unsuccessful for a number of reasons. Such devices tend to suffer from a difficulty in fabrication due to the many layered structure required as well as a low power output due to the very short length of gain medium in the cavity. The short cavity is also a source of higher noise and broader linewidth. The broader linewidth limits the transmission distance of the signal from these sources due to dispersion effects in the fibre.

The effect of chromatic dispersion is a problem in the telecommunications field. Different spectral components of a signal pulse travel at slightly different group velocities along a fibre. Thus, pulse broadening occurs. Pulse broadening causes interference between pulses and an increase in the bit error rate. Pulse broadening also increases cross-talk between adjacent wavelength channels. Also the further the pulse travels the more it broadens. Thus, the bit rate is limited by the total dispersion in an optical link, usually dominated by the fibre length, in combination with the pulse broadening. If the optical signal source exhibits higher chirp, the pulse broadens more rapidly and the link length supported at a given bit rate is reduced. A low chirp source is therefore desirable in optical communications.

What is desired in a surface emitting laser structure, which can provide useful amounts of output power without the detrimental spatial hole burning problems associated with the prior art phase shifted designs. What is also desired is a structure which has low chirp.

The present invention seeks to provide an improved surface emitting laser structure, and a method of fabricating surface emitting semiconductor lasers.

According to one aspect of this invention there is provided a surface emitting semiconductor laser comprising a semiconductor laser structure having an active layer, opposed cladding layers contiguous to said active layer, a substrate and electrodes by which current can be injected into said semiconductor laser structure to cause said laser structure to emit an output signal in the form of at least a surface emission wherein a second order gain coupled grating is associated with said active layer of said laser structure, said gain coupled grating having a plurality of grating elements having periodically alternating larger and smaller gain values when said current is injected into said laser structure, said grating being sized and shaped to generate counter-running guided modes within the cavity, and means are provided for shifting a phase of said counter-running guided modes within the cavity to alter a mode profile to increase a near filed intensity of said output signal, and wherein said alternating grating elements having a larger gain value have a refractive index which decreases as more gain is applied to ameliorate spatial hole burning.

Preferably said gain coupled detraction grating is optically active and is formed in a gain medium in the active layer.

According to another aspect of this invention there is provided a surface emitting semiconductor laser comprising a semiconductor laser structure having an active layer, opposed cladding layers contiguous to said active layer, a substrate and electrodes by which current can be injected into said semiconductor laser structure to cause said laser structure to emit an output signal in the form of at least a surface emission wherein a second order loss coupled grating is associated with said active layer of said laser structure, said loss coupled grating having a plurality of grating elements having periodically alternating larger and smaller gain values when said current is injected into said laser structure, said grating being sized and shaped to generate counter-running guided modes within the cavity; and means are provided for shifting a phase of said counter-running guided modes within the cavity to alter a mode profile to increase a near field intensity of said output signal, and wherein said alternating grating elements having a lower gain value have a characteristic that sufficient photo-excited carrier generation occurs as an applied gain increases to compensate for carrier depletion in the active layer, to ameliorate spatial hole burning.

Preferably the means for phase shifting comprises a modulated pitch formed in the grating.

The modulated pitch grating may be sized and shaped to even out a photo density across the laser structure.

Preferably, in use of the laser, said modulated pitch grating generates a generally Gaussian shaped surface emission profile.

Advantageously, in use of said laser, said modulated pitch grating causes one or more secondary modes to have surface emissions approaching zero at a centre of said laser structure.

Conveniently, in use of said laser, said semiconductor laser structure emits a second output signal in the form of an edge emission in addition to the signal emitted as a surface emission.

Conveniently any adjacent pair of said alternating grating elements form a grating period and the grating elements having a larger gain value comprise about 75% of the length of the said grating period.

It is possible to form an array of side-by-side surface emitting semiconductor lasers as defined above, wherein said lasers are in the form of a coherent array of N lasers to form a pump source having a power factor of N².

The grating may comprise an integral number of grating periods on either side of the phase shift.

Preferably the structure further includes an adjoining region at least partially surrounding the grating in plan view, the adjoining region being formed of a material having a resistance sufficient to electrically isolate said grating, when the laser is in use.

In one embodiment said adjoining region further includes integrally formed absorbing regions located at either end of said gain coupled grating. In another embodiment the laser has a photo-detector (200), the laser further including a feedback connected to said photo-detector to compare a detected output signal with a desired output signal and an adjuster for adjusting an input current to maintain said output signal at a desired characteristic.

The photo-detector may be integrally formed with the lasing structure.

Preferably the adjoining region is formed from material having resistance sufficient to electrically isolate said grating when said laser is in use.

Conveniently one of said electrodes may include a signal emitting opening.

One of said electrodes may be sized and shaped to laterally confine an optical mode within a region through which current is being injected.

Preferably said laterally confining electrode is a ridge electrode.

One embodiment of the invention comprises an array of surface emitting semi-conducted layers as defined above wherein said array includes two or more of said layers on a common substrate.

A plurality of surface emitting semiconductor laser devices may be arranged as an array of surface emitting semiconductors wherein each of two or more lasers produces an output signal having a different wavelength and output power and can be individually modulated. In an alternative arrangement where there is an array of semiconductor lasers each of two or more lasers may produce an output signal having the same wavelength.

According to a further aspect of this invention there is provided a method of fabricating surface emitting semiconductor lasers, said method comprising the steps of forming a plurality of semiconductor laser structures by forming, in successive layers on a common wafer substrate; a first cladding layer, an active layer and a second cladding layer on said wafer substrate; forming a plurality of second order gratings associated with said active layer on said water substrate, with alternating grating elements of larger and smaller gain values wherein a refractive index of said larger gain value elements decreases as more gain is applied to ameliorate spatial hole burning; forming a phase shifter in said grating to alter a mode profile of an output signal from said semiconductor laser; forming electrodes on each of said semiconductor laser structures on said wafer substrate for injecting current into each of said gratings; and testing each of said semiconductor laser structures by injecting a testing current into said structures while the same are still connected to said common wafer substrate.

The method may further comprise the step of simultaneously forming adjoining regions between said plurality of distributed diffraction gratings.

The method may additionally include the step of sizing and shaping at least one of said electrodes associated with each grating to laterally confine an optical mode of each of said semi-conductor laser structures.

The method may further include the step of forming at either end of each of said gratings an absorbing region in said adjoining region.

The method may further include the step of cleaving said wafer along said adjoining regions to form an array of lasers.

Reference has been made above to cladding layers. The cladding layers may take the form of confinement layers. It is envisaged that a preferred embodiment of the invention may provide a surface emitting laser structure which is suitable for telecommunications applications and which avoids or minimises the defects of the prior art. A preferred embodiment of the invention may comprise a low-cost optical signal source that is capable of generating signals suitable for use in the optical broadband telecommunications signal range. A preferred signal source would be in the form of a surface emitting semiconductor laser which can be fabricated using conventional semiconductor manufacturing techniques and yet which would have high yields than current techniques. Thus, it is envisaged that embodiments of the invention may provide signal sources at a lower cost than as compared to the prior art techniques.

It is preferred that the signal source of an embodiment of the invention would have enough power, wavelength stability and precision for broadband telecommunications applications without encountering impractical limits due to spatial hole burning. More particularly it is envisaged that embodiments of the invention will constitute a laser structure where the mode shape is optimised to permit fibre coupling, and yet which can be made using conventional lithographic techniques in the semiconductor art. Thus, a preferred embodiment of the invention, is a surface emitting laser which includes a means to ameliorate spatial hole burning to permit practical values of output power to arise from the laser. It is envisaged that a device of this type would display minimal chirp to permit signal transportation and manipulation without unacceptable pulse broadening.

It is envisaged that embodiments of the invention may constitute semiconductor laser signal sources having a signal output that is easily and efficiently coupled to a single mode optical fibre. Such devices may preferably be fabricated as an array on a single wafer-based structure and may be integrally and simultaneously formed or fabricated, as will be described, with adjacent structures such as signal absorbing adjoining regions and photo-detector devices.

It is envisaged that embodiments of the invention may be manufactured in an efficient manner. The larger the number of array signal sources, the greater the need for a low fault rate fabrication. Thus, for example, a forty source array fabricated at a yield of 98% per source will produce an array fabrication yield of only 45%. Thus improved fabrication yields are important to cost-efficient array fabrication.

It is envisaged that a preferred embodiment of the invention will be an array of laser sources such that each laser source can be fabricated to operate at the same or to different wavelengths, and most preferably to wavelengths within the telecommunications signal bands. It is envisaged that such a device could have a built-in detector that, in conjunction with an external feedback circuit, can be used for signal monitoring and maintenance.

### BRIEF DESCRIPTION OF THE DRAWINGS

Reference will now be made, by way of example only, to preferred embodiments of the present invention by reference to the attached figures, in which:
Figure 1 is a side view of one embodiment of a surface emitting semiconductor laser according to the present invention having a quarter-wave phase shifted second order grating formed in a gain medium;
Figure 2 is an end view of the embodiment of Figure 1;
Figure 3 is a schematic plot of a comparison between an index coupled and a gain coupled quarter-wave phase shifted DFB laser to illustrate aspects of the present invention;
Figure 4 is a plot of a normalised gain difference DaL, as a function of bias current for the quarter-wave phase shifted DFB lasers of Figure 3;
Figure 5 is a side view of a second embodiment of a surface emitting semiconductor laser according to the present invention having a second order grating formed in an absorbing or loss layer;
Figure 6 is an end view of the embodiment of Figure 5;
Figure 7 is a top view of a pitch modulated design according to the present invention;
Figure 8 is a schematic of an optical near-field intensity vs. the distance along the laser cavity of the primary mode for the embodiment of Figure 1 of the present invention;
Figures 8a, 8b and 8c are schematics of a normalized field distribution of photon density and surface emission for the three primary modes of the embodiment of Figure 7;
Figure 9 is a top view of a further embodiment of the present invention showing termination regions in the form of absorbing regions at either end of a laser cavity;
Figure 10 is top view of a further embodiment of the invention of figure 8 wherein one of said termination regions is a detector; and
Figure 11 is top view of an array of surface emitting semiconductor laser structures on a common substrate for generating wavelengths 1 to N.

### DETAILED DESCRIPTION OF THE PREFERRED EMBODIMENTS

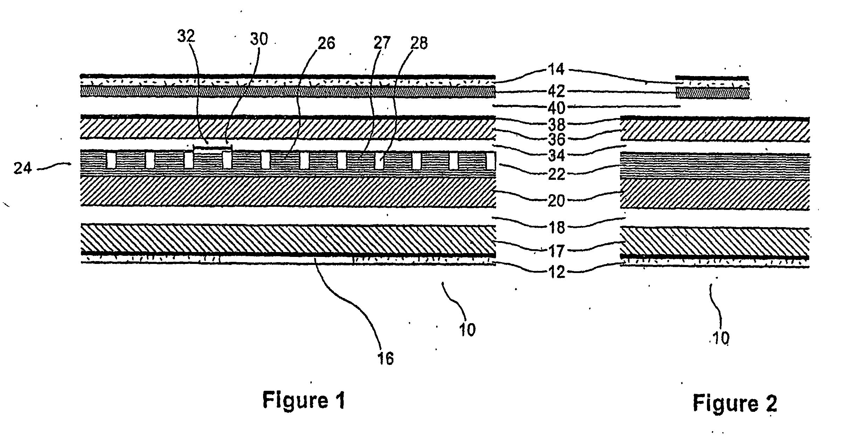

Figure 1 is a side view of one embodiment of a surface emitting semiconductor laser structure 10 according to the present invention, while Figure 2 is an end view of the same structure. The laser structure 10 is comprised of a number of layers built up one upon the other using, for example, standard semiconductor fabrication techniques. It will be appreciated that the use of such known semiconductor fabrication techniques for the present invention means that the present invention may be fabricated efficiently in large numbers without any new manufacturing techniques being required.

In this disclosure the following terms shall have the following meanings. A p- region of a semiconductor is a region doped with electron acceptors in which holes (vacancies in the valence band) are the dominant current carriers. An n- region is a region of a semiconductor doped so that it has an excess of electrons as current carriers. An output signal means any optical signal which is produced by the semiconductor laser of the present invention. The mode volume means the volume in which the bulk of the optical mode exists, namely, where there is significant light (signal) intensity. For example, the mode volume could be taken as the boundary enclosing 80% of the optical mode energy. For the purposes of this disclosure, a distributed diffraction grating is one in which the grating is associated with the active gain length or absorbing length of the lasing cavity so that feedback from the grating causes interference effects that allow oscillation or lasing only at certain wavelengths, which the interference reinforces.

The diffraction grating of the present invention is comprised of grating or grid elements, which create alternating gain effects. Two adjacent grating elements define a grating period. The alternating gain effects are such that a difference in gain arises in respect of the adjacent grating elements with one being a relatively high gain effect and the next one being a relatively low gain effect. The present invention comprehends that the relatively low gain effect may be a small but positive gain value, may be no actual gain or may be an absorbing or negative value. Thus, the present invention comprehends any absolute values of gain effect in respect of the grating elements, provided the relative difference in gain effect is enough between the adjacent grating elements to set up the interference effects of lasing at only certain wavelengths. The present invention comprehends any form of grating that can establish the alternating gain effects described above, including loss coupled and gain coupled gratings in the active region and carrier blocking gratings whether in the active region or not.

The overall effect of a diffraction grating according to the present invention may be defined as being to limit laser oscillation to one of two longitudinal modes which may be referred to as a single-mode output signal. According to the present invention various techniques are employed to further design the laser such that the mode profile is capable of being effectively coupled to a fibre.

As shown in Figure 1, the two outside layers 12 and 14 of the laser structure 10 are electrodes. The purpose of the electrodes is to be able to inject current into the laser structure 10. It will be noted that electrode 12 includes an opening 16. The opening 16 permits the optical output signal to pass outward from the laser structure 10, as described in more detail below. Although an opening is shown, the present invention comprehends the use of a continuous electrode, providing the same is made transparent, at least in part, so as to permit the signal generated to pass out of the laser structure 10. Simple metal electrodes, having an opening 16, have been found to provide reasonable results and are preferred due to ease of fabrication and low cost.

Adjacent to the electrode 12 is an n+ InP substrate, or wafer 17. Adjacent to the substrate 17 is a buffer layer 18 which is preferably comprised of n-InP. The next layer is a confinement layer 20 formed from n-InGaAsP. The generic composition of this and other quaternary layers is of the form InₓGa₁₋ₓAs_{y}P_{1-y} while ternary layers have the generic composition In₁₋ₓGaₓAs. The next layer is an active layer 22 made up of alternating thin layers of active quantum wells and barriers, both comprised of InGaAsP or InGaAs. As will be appreciated by those skilled in the art InGaAsP or InGaAs is a preferred semiconductor because these semiconductors, within certain ranges of composition, are capable of exhibiting optical gain at wavelengths in the range of 1200 nm to 1700 nm or higher, which comprehends the broadband optical spectra of the S-band (1300-1320 nm), the C-band (1525nm to 1565 nm) and the L-band (1568 to 1610 nm). Other semiconductor materials, for example GaInNAs, InGaAlAs are also comprehended by the present invention, provided the output signal generated falls within the broadband range. Another relevant wavelength range of telecommunications importance for which devices following this invention could be designed using appropriate material compositions (for example InGaAs/GaAs) is the region from 910 to 990 nm, which corresponds to the most commonly encountered wavelength range for pumping optical amplifiers and fiber lasers based on Er, Yb or Yb/Er doped materials.

In the embodiment of Figure 1, a diffraction grating 24 is formed in the active layer 22. The grating 24 is comprised of alternating high gain portions 27 and low gain portions 28. Most preferably, the grating 24 is a regular grating, namely has a consistent period across the grating, and is sized, shaped and positioned in the laser 10 to comprise a distributed diffraction grating as explained above. In this case, the period of the grating 24 is defined by the sum of a length 32 of one high gain portion 27 and a length 30 of the adjacent low gain portion 28. The tow gain portion 28 exhibits low or no gain as compared to the high gain portion 27 as in this region most or all of the active structure has been removed. According to the present invention, the grating 24 is a second order grating, namely, a grating which results in output signals in the form of surface emission. As can now be appreciated, since the grating 24 of this embodiment is formed in the active gain layer it is referred to as a gain coupled design.

Located centrally in the grating 24 is a means for phase shifting, which comprises a slightly wider high gain "tooth" 26. This tooth 26 is sized and shaped to deliver a phase shift of one quarter of a wavelength. The present invention comprehends other forms of phase shift elements as will be understood by those skilled in the art. What is needed is to provide enough of a phase shift to the grating to alter the near field intensity profile to change the dominant mode from a dual peaked configuration to a single peaked configuration where the peak is generally located over the phase shift. Such a mode profile can be more efficiently coupled to a fibre than the dual lobed profile. Thus provided that the mode profile is altered to improve coupling efficiency, the amount of the phase shift, and the manner of effecting the phase shift can be varied without departing from the scope of the present invention.

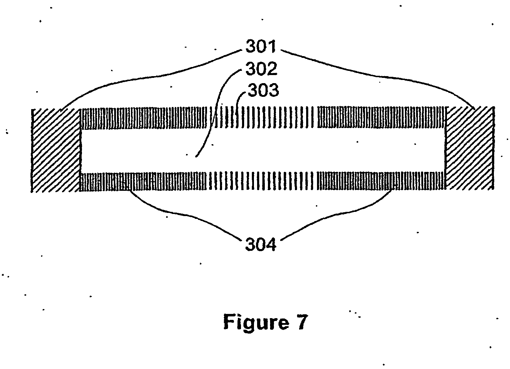

For example, multiple phase shifts may be employed yielding an overall quarter wave shift, e.g. two λ/8, or two 3 λ/8 or other combinations are comprehended. As well a continuously chirped grating or a modulated pitch grating are also comprehended although these are more difficult to fabricate. A modulated pitch grating according to the present invention is illustrated in Figure 7 which shows end absorbing regions 301, a ridge electrode 302, and equal length side grating sections 304 surrounding middle grating section 303. As shown, the middle grating period is slightly different than the grating period in sections 304. In this Figure 7 a modulated pitch grating is illustrated, in which the phase shift is distributed across the grating.

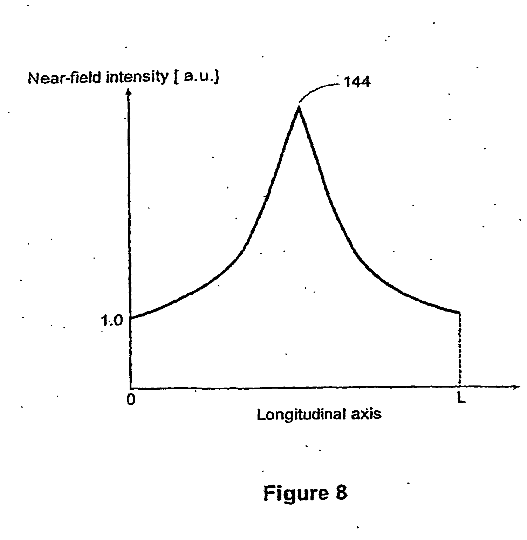

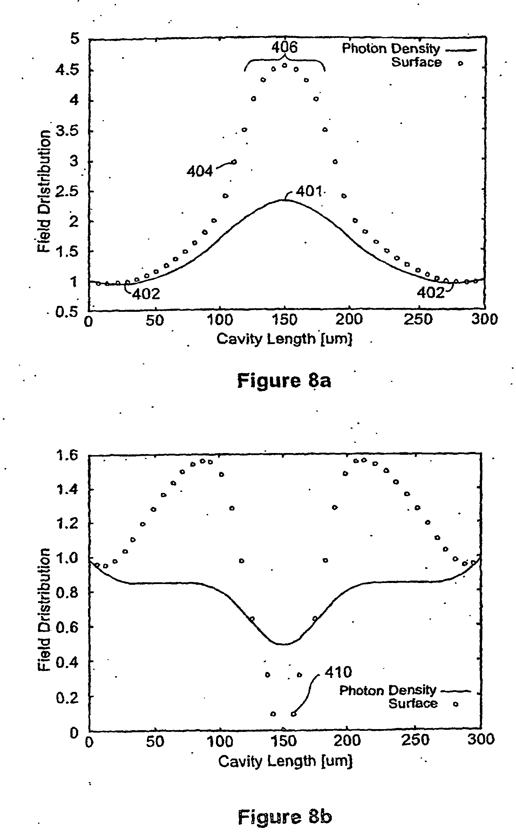

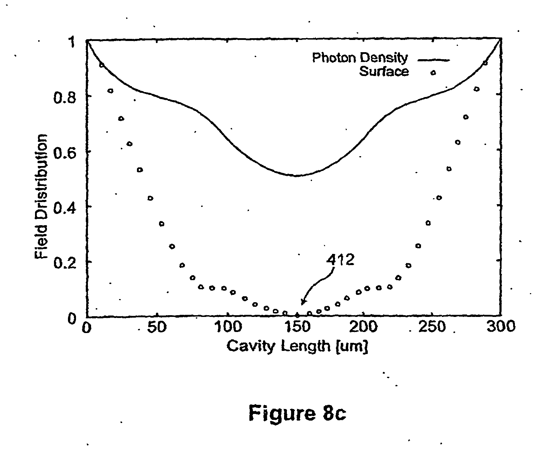

Attached as Figures 8a, 8b, and 8c are theoretical plots for the field density vs cavity length for both photon density and surface emissions. Three plots (8a, 8b and 8c) are provided of the three fundamental modes namely 0 order mode, -1st mode and +1st mode respectively. It will be noted from 8a, that for the primary (i.e. lasing) 0 order mode, that the photon density has a fairly even distribution across the laser structure or cavity. In fact, the peak 401 shown is less than 2.5, whereas the low 402 is slightly under 1. Such a generally even distribution of photon density reduces spatial hole burning problems. Also from Figure 8a can be seen that the surface emission profile 404 is generally rounded or Gaussian in shape at 406, meaning that the surface emission is amenable to being coupled to a fibre for telecommunication applications.

Also, the two secondary modes 8b and 8c show the normalized near-field distribution trending to zero at the centre of the cavity at 410 and 412 respectively. As such very little of the secondary modes will couple with the fibre, yielding high side mode suppression while achieving a reduction (amelioration) of spatial hole burning. This configuration also exhibits low chirp. In summary, although many different types of structures can be used to introduce a phase shift, a modulated pitch design is one preferred form. In this specification, the term modulated pitch design means a grating which has a slightly different period at a middle of the cavity than at the ends. Most preferably, such a period change is introduced gradually across the grating, rather than abruptly at one tooth as in the previously described embodiment.

Returning to Figure 1, the next layer above the grating 24 is a p-InGaAsP confinement layer 34. Located above the confinement layer 34 is a p-InP buffer region 36. Located above layer 36 is a p-InGaAsP etch stop layer 38. Then, a p-InP cladding layer 40 is provided surmounted by a p⁺⁺-InGaAs cap layer 42.

It will be understood by those skilled in the art that a semiconductor laser built with the layers configured as described above can be tuned to produce an output signal of a predetermined wavelength as the distributed feedback from the diffraction grating written in the active layer renders the laser a single mode laser. The precise wavelength of the output signal will be a function of a number of variables, which are in turn interrelated and related to other variables of the laser structure in a complex way. For example, some of the variables affecting the output signal wavelength include the period of the grating, the index of refraction of the active, confinement, and cladding layers (which in turn typically change with temperature as well as injection current), the composition of the active regions (which affects the layer strain, gain wavelength, and index), and the thickness of the various layers that are described above. Another important variable is the amount of current injected into the structure through the electrodes. Thus, according to the present invention by manipulating these variables a laser structure can be built which has an output with a predetermined and highly specific output wavelength. Such a laser is useful in the communications industry where signal sources for the individual channels or signal components which make up the DWDM spectrum are desired. Thus the present invention comprehends various combinations of layer thickness, gain period, injection current and the like, which in combination yield an output signal having a power, wavelength and bandwidth suitable for telecommunications applications.

However, merely obtaining the desired wavelength and bandwidth is not enough. A more difficult problem solved by the present invention is to produce the specific wavelength desired from a second order grating (and thus, as a surface emission) in such a manner that it can be controlled for efficient coupling, for example, to an optical fibre. The spatial characteristics of the output signal have a big effect on the coupling efficiency, with the ideal shape being a single mode, single-lobed Gaussian. For surface emitting semiconductor lasers the two primary modes include a divergent dual-lobed mode, and a single-lobed mode. The former is very difficult to couple to a single mode fibre as is necessary for most telecommunications applications because the fibre has a single Gaussian mode.

As noted above, SMSR refers to the suppression of the unwanted mode in favour of the wanted mode. According to the present invention, to achieve good SMSR operation from the surface of the laser 10 requires careful attention to the design of the duty cycle of the grating 24 and thus to the spatial modulation of the gain through the active layer 22. In this description, the term duty cycle means the fraction of the length of one grating period that exhibits high gain as compared to the grating period. In more simple terms, the duty cycle may be defined as the portion of the period of the grating 24 that exhibits high gain. This parameter of duty cycle - is controlled in gain coupled lasers, such as illustrated in figure 1, by etching away portions of the active layers, with the remaining active layer portion being the duty cycle. Alternatively, the active gain layers can be left intact and the grating can be etched into a current blocking layer, with the fraction of current blocking layer etched away corresponding to the duty cycle.

In Figure 1, it can now be understood that the second order distributed diffraction grating is written by etching the gain medium to form the grating 24. As a result, the two fundamental modes of the semiconductor laser 10 exhibit different surface radiation losses (which is the output of the laser) and therefore have very different gains. Only one mode (the mode with the lowest gain threshold) will lase, resulting in good SMSR. The present invention comprehends that the desired lasing mode is single lobed and approximates a Gaussian profile. In this way the lasing mode can be more easily coupled to a fibre, since the profile of the power or signal intensity facilitates coupling the output signal to a fibre. The phase shifted second order active-coupled grating has three modes that can lase, with two dual lobed modes that have a higher gain threshold and a single lobed mode having the lowest gain threshold. Therefore the dominant mode is a single-lobed profile peaked at the position of the phase shift, which according to the present invention is placed at the midpoint of the laser structure for optimal coupling into a fibre.

In addition, according to the present invention, a means for ameliorating spatial hole burning is provided. In this sense ameliorate means to make better, not to eliminate. Thus, the present invention comprehends improving the performance of the laser structure over prior art structures by reducing the harmful limitations imposed by spatial hole burning. As those skilled in the art will appreciate, spatial hole burning is not eliminated, but merely ameliorated to permit the lasers of the present invention to operate at higher output power without degrading the single mode operation, which normally occurs in phase-shifted designs, leading to unacceptable chromatic dispersion or pulse broadening.

The phase shifted DBF lasers with a grating associated with the active layer according to the present are robust to spatial hole burning due to the means for ameliorating spatial hole burning. More specifically, the present invention provides a DFB laser with a corrugated active layer (or a corrugation associated with the active layer, for example in an absorption layer in the mode volume) such that increasing the carrier injection (to increase gain) results in more carriers in the high gain region, but the refractive index decreases, due to the plasma effect. As a result, the index coupling coefficient decreases, which ameliorates longitudinal spatial hole burning. Thus, due to the properties of the grating being associated with the active layer, spatial hole burning is ameliorated. Thus, the present invention comprehends a phase shifted second order grating associated with the active layer to take advantage of the mode profile of a phase shifted index grating, while at the same time including the self suppression of the spatial hole burning as aforesaid.

Although there is no limit on the choice of duty cycle, if it is preferred to operate the laser of the present invention with as much power as is reasonably possible, a duty cycle of about 0.75 is believed to be preferred. However, other duty cycle values can also be used, from about 0.25 to 0.75 or even higher. At lower duty cycle less of the grating generates gain, thus increasing the threshold current and reducing the overall power and efficiency available from the laser.

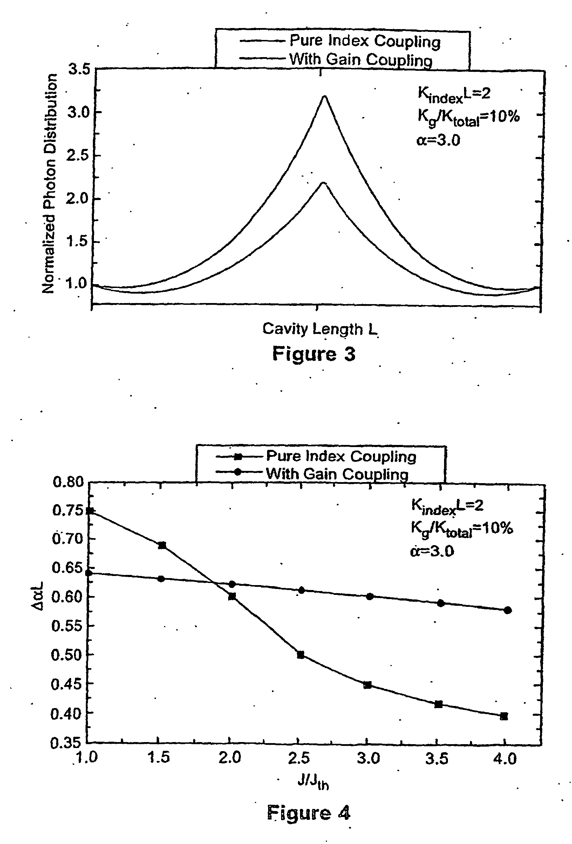

To illustrate this effect, Figure 3 illustrates certain characteristics of two different second order quarter phase shifted DFB lasers. One has an index coupled grating and the other a gain coupled grating. For the purposes of making a fair comparison, it is assumed that both lasers have the same normalised index coupling coefficient KᵢL of 2 and a coupling coefficient to the radiation field of 3 cm⁻¹. Further it is assumed that the gain coupling coefficient ratio K_{g}/Kₜₒₜₐₗ of DFB laser with gain grating is 10%. Figure 1 thus illustrates a comparison in which the field intensity has been normalised at both ends of the cavity. It can be seen that the intensity peak of the index grating is greater than the intensity peak of the gain coupled grating.

In Figure 4 a representation of a normalised gain difference ΔαL as a function of bias or injection current of the same two lasers as in Figure 3 are plotted. This provides an indication of side mode suppression ratio. As can be seen from the figure, the normalised gain difference of a laser with index grating decreases rapidly with increasing bias due to mode competition. Therefore in a quarter-wave phase shifted structure with index grating, spatial hole burning is a limiting factor at high power levels, and is a source of multimode operation and hence chirp. In contrast, the normalized gain difference of the gain grating laser structure of the present invention remains almost constant across variations in biasing current (and therefore output power). Thus, the present invention provides in one embodiment a quarter-wave phase shifted structure that has a low chirp compared to index coupled gratings of the prior art.

In semiconductor lasers, multimode operation is a source of chirp. Gain or loss coupled DFB lasers have an inherent mechanism for mode selectivity. Therefore, the side mode suppression ration is very high, and hence the chirp is low. More particularly, in semiconductor DFB lasers, nonuniformity of the laser field causes non-uniform carrier distribution within the laser cavity due to the stimulated recombination and spatial hole burning. In index coupled gratings, the longitudinal mode stability is degraded through the change of the refractive index distribution within the cavity. The present invention comprehends ameliorated spatial hole burning due to gain coupled grating as illustrated by the foregoing figures.

Turning to Figure 2, a side-view of the laser structure of Figure 1 is shown. As can be seen in Figure 2, the electrodes 12 and 14 permit the application of a voltage across the semiconductor laser structure 10 to encourage lasing as described above. Further, it can be seen that the ridge formed by the top layers serves to confine the optical mode laterally to within the region through which current is being injected. While a ridge waveguide is shown in this embodiment it is comprehended that a similar structure could be fabricated using a buried heterostructure design to confine the carriers and optical field laterally.

Other forms of gain coupled designs are comprehended as a means to implement the present invention. For example instead of etching the active region as described above, a further highly n-doped layer can be deposited above the active layer and a grating can be made in this layer. This layer would then be not active optically and thus neither absorbs nor exhibits gain. Instead, it blocks charge carriers from being injected into the active layer wherever it has not been etched away. This structure for an edge emitting gain coupled laser is taught in C. Kazmierski, R. Robein, D. Mathoorasing, A. Ougazzaden, and M. Filoche, *IEEE, J. Select. Topics Quantum Electron.,* vol. 1, pp. 371-374, June 1995. The present invention, comprehends modifying such a structure to render it surface emitting and to include a phase shift as aforesaid.

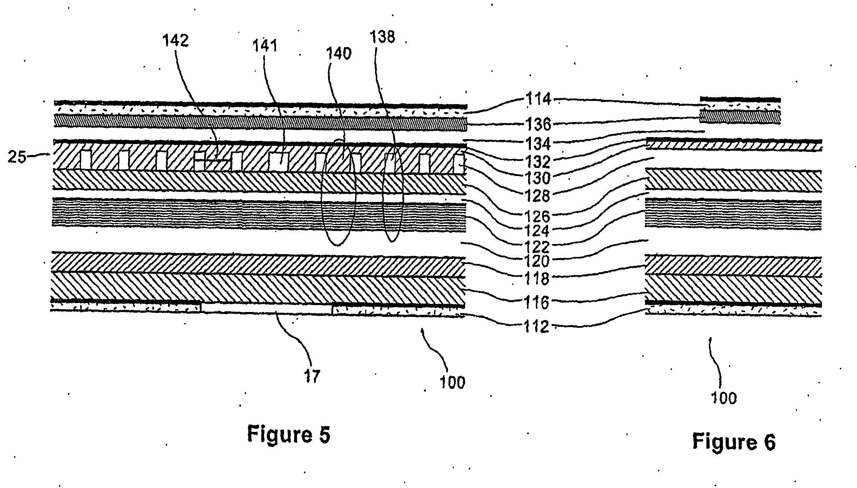

Turning to Figure 5, a further embodiment of a surface emitting semiconductor laser structure 100 is shown. In this embodiment, electrodes 112 and 114 are provided at the top and bottom. Adjacent to the electrode 112 is an n+InP substrate 116 followed by a n-InP buffer 118. An opening 117 is provided in electrode 112. A first confinement n-InGaAsP layer 120 is provided above which is located an active region 122 comprised of InGaAsP or InGaAs quantum well layers separated by InGaAsP or InGaAs barrier layers. Then, a p-InGaAsP confinement region 124 is provided with a p-InP buffer region 126 there-above. A grating 125 is formed in the next layer, which is a p- or n-InGaAs or InGaAsP absorption layer 128. A further p-InP buffer layer 130 is followed by a p-InGaAsP etch stop layer 132. Then, a p-InP cladding layer 134 is provided along with a p⁺⁺-InGaAs cap layer 136 below the electrode 114. As will now be appreciated, this embodiment represents a second (or higher) order grating which is formed by providing an absorbing layer and etching or otherwise removing the same to form a loss coupled device. The grating 125 is comprised of a periodically reoccurring loss or absorption elements. When taken together with the continuous gain layer 122 (even though the gain layer is not on the same level as the absorption layer) this grating 125 can be viewed as a grating having periodically repeating high gain elements 140 and low gain (which may be no gain or even net loss) elements 138. The combination of any one high gain element 140 and one low gain element 138 defines a period 142 for said grating 125. A quarter wavelength phase shift is provided by means of a phase shift tooth 141. This is equivalent to the tooth 26 of the first embodiment in altering a near-field mode profile of the laser.

Figure 6 shows the semiconductor laser structure of Figure 5 in end view. As can be noted, a current can be injected through the electrodes 112 and 114 to the semiconductor laser structure 100 for the purpose of causing lasing in as described above. As in Figure 2, the ridge provides the lateral confinement for the optical field.

As discussed above with respect to the gain-coupled grating of the present invention, the loss coupled grating of Figures 5 and 6 also include a means for ameliorating spatial hole burning. In the loss coupled embodiment carrier depletion in the active region is compensated for by photoexcited carrier generation in an absorptive layer. Again this has an effect in reducing the spatial hole burning. Moreover, because of overlapping of the intensity distribution and the loss modulation, the present invention is more robust to external feedback (this applies equally to the gain coupled design.) As will be understood by those skilled in the art, this effect is not the case for the index-coupled designs of the prior art.

Figure 8 is a schematic of an optical near-field intensity versus the distance along the laser cavity, and is generally applicable to both of the previously described embodiments of Figures 1 and 2 and 5 and 6. As shown, at the middle of the laser cavity, the mode 2 (the divergent dual lobed) field has been modified by phase shifting to form a peak 144. Thus Figure 8 illustrates the need for the opening 16 in the electrode 12 in the middle of the cavity to let out the signal as shown in Figure 1. The plot of Figure 8 can be compared to that of 8a, and it can now be seen that the modulated period grating adds both to the evenness of the photon density distribution, as well as to the rounding of the peak of the surface emissions.

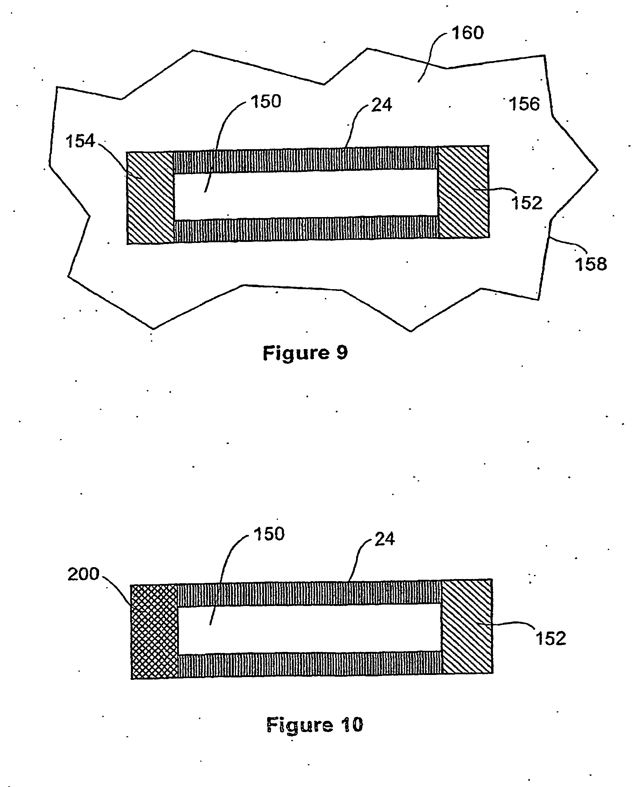

Figure 9 shows a top view of a further embodiment of the present invention, where the grating region 150 includes finished end portions 152, 154 for improved performance. As can be seen the grating 150 can be written onto a wafer 156 (shown by break line 158) using known techniques. The grating 150 so written can be surrounded by an adjoining region 160 that separates and protects the grating 150. Because the present invention is a surface emitting device, rather than cleaving the grating end portions as in the prior art edge emitting lasers, the present invention contemplates cleaving, to the extent necessary, in the non-active adjoining region 160. Thus, no cutting of the grating 150 occurs during cleaving and the properties of each of the gratings 150 can be specifically designed, predetermined and written according to semiconductor lithographic practices. Thus, each grating can be made with an integral number of grating periods and each adjacent grating on wafer 156 can be written to be identical or different from its neighbours. The only limit of the grating is the writing ability of the semiconductor fabrication techniques. Importantly, unlike the prior art edge emitting semiconductor lasers the grating properties will not change as the laser structures are packaged.

The present invention further comprehends making the grating termination portions 152, 154 absorbing regions. This is easily accomplished by not injecting current into the termination regions as the active layer is absorbing when not pumped by charge injection. As such, these regions will strongly absorb optical energy produced and emitting in the horizontal direction, thus fulfilling the function of the anti-reflective coatings of the prior art without further edge finishing being required. Such absorbing regions can be easily formed as the layers are built up on the wafer during semiconductor manufacturing without requiring any additional steps or materials. In this manner a finishing step required in the prior art is eliminated, making laser structures 10 according to the present invention more cost efficient to produce than the prior art edge emitting lasers. It will therefore be appreciated that the present invention contemplates cleaving (where necessary or desirable) through an adjoining region 160 distant from the actual end of the grating 150 whereby the prior art problems associated with cleaving the grating and thereby introducing an uncontrolled phase shift into the cavity are completely avoided.

A further advantage of the present invention can now be understood. The present invention comprehends a method of manufacturing where there is no need to cleave the individual elements from the wafer, nor is there any need to complete the end finishing or packaging of the laser structure before even beginning to test the laser structures for functionality. For example, referring to Figure 1, the electrodes 12, 14 are formed into the structure 10 as the structure is built and still in a wafer form. Each of the structures 10 can be electrically isolated from adjacent structures when on wafer, by appropriate patterning and deposition of electrodes on the wafer, leaving high resistance areas in the adjoining regions 160 between gratings as noted above. Therefore, electrical properties of each of the structures can be tested on wafer, before any packaging steps occur, simply by injecting current into each grating structure 150 on wafer. Thus, defective structures can be discarded or rejected before any packaging steps are taken (even before cleaving), meaning that the production of laser structures according to the present invention is much more efficient and thus less expensive than in the prior art where packaging is both more complex and required before any testing can occur. Thus cleaving, packaging and end finishing steps for non-functioning or merely malfunctioning laser structures required in the prior art edge emitting laser manufacture are eliminated by the present invention.

Figure 10 shows a further embodiment of the present invention including a detector region 200 located at one side of the grating region. The detector region 200 can be made integrally with the laser structure by reverse biasing the layers of the detector region 200 to act as a photodetector. This detector is inherently aligned with the surface emitting laser 10 and is easily integrated by being fabricated at the same time as the laser structure, making it very cost efficient to include. In this way the signal output can be sensed by the detector 200 and the quality of the optical signal, in terms of power stability, can be monitored in real time. This monitoring can be used with an external feedback loop to adjust a parameter, for example the injection current, which might be varied to control small fluctuations in the output power. Such a feedback system allows the present invention to provide very stable or steady output signals over time, to tune the output signal as required or to compensate for changes in environment such as temperature changes and the like which might otherwise cause the output signal to wander. Variations in an output optical signal can be therefore compensated for by changes in a parameter such as the current injected into the laser. In this way, the present invention contemplates a built-in detector for the purpose of establishing a stable signal source, over a range of conditions, having a desired output wavelength.

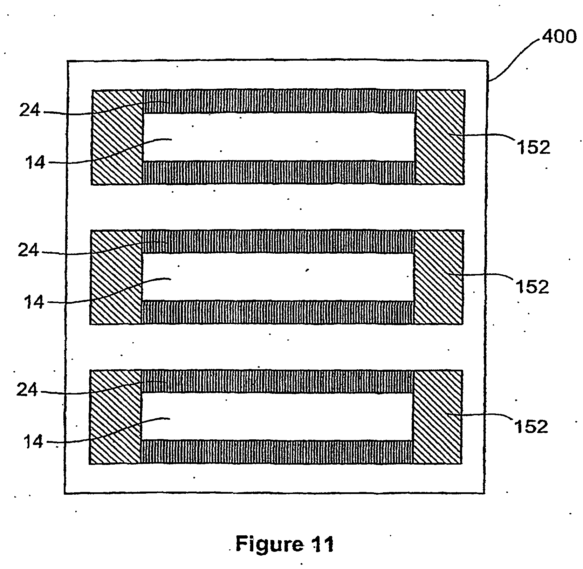

Figure 11 is a top view of an array of semiconductor laser structures 10 according to the present invention all formed on a single common substrate 400. In this case, each grating 24 can be designed to produce a specific output (specific signal) in terms of wavelength and output power. The present invention contemplates having each of the adjacent signal sources which form the array at the same wavelength or specific signal as well as having each of them at a different wavelength or specific signal. Thus, the present invention contemplates a single array structure which simultaneously delivers a spectrum of individual wavelengths suitable for broadband communications from a plurality of side by side semiconductor laser structures. Each laser structure or signal source may be independently modulated and then multiplexed into a DWDM signal. Although three are shown for ease of illustration, because of the flexibility in design, the array can include from two up to forty or more individual wavelength signal sources on a common substrate 400. It will also be understood that where each of the laser sources are tuned to the same frequency, and are coherent, then the array of N lasers will have a power factor of N².

It will be appreciated by those skilled in the art that while reference has been made to preferred embodiments of the present invention various alterations and variations are possible without departing from the scope of the broad claims attached. Some of these variations have been discussed above and others will be apparent to those skilled in the art. For example, while preferred structures are shown for the layers of the semiconductor laser structure of the invention other structures may also be used which yield acceptable results. Such structures may be either loss coupled or gain coupled as shown. What is believed important is to have a phase shift in the second order DFB grating and a means to ameliorate spatial hole burning.

## Claims

1. A surface emitting semiconductor laser comprising a semiconductor laser structure (10) having an active layer (22), opposed cladding layers (20, 34) contiguous to said active layer, a substrate and electrodes (12, 14) by which current can be injected into said semiconductor laser structure to cause said laser structure to emit an output signal in the form of at least a surface emission **characterised in that** a second order gain coupled grating (24) is associated with said active layer (22) of said laser structure, said gain coupled grating having a plurality of grating elements (27, 28) having periodically alternating larger and smaller gain values when said current is injected into said laser structure, said grating being sized and shaped to generate counter-running guided modes within the cavity, and means (26) are provided for shifting a phase of said counter-running guided modes within the cavity to alter a mode profile to increase a near filed intensity of said output signal, wherein said alternating grating elements (27, 28) having a larger gain value have a refractive index which decreases as more gain is applied to ameliorate spatial hole burning.

2. A surface emitting semiconductor laser as claimed in Claim 1 wherein said gain coupled diffraction grating (24) is optically active and is formed in a gain medium in the active layer (22).

3. A surface emitting semiconductor laser comprising a semiconductor laser structure (100) having an active layer (122), opposed cladding layers (120, 126) contiguous to said active layer, a substrate and electrodes (112, 114) by which current can be injected into said semiconductor laser structure to cause said laser structure to emit an output signal in the form of at least a surface emission **characterised in that** a second order loss coupled grating (125) is associated with said active layer of said laser structure, said loss coupled grating having a plurality of grating elements (138, 140) having periodically alternating larger and smaller gain values when said current is injected into said laser structure, said grating being sized and shaped to generate counter-running guided modes within the cavity; and means (141) are provided for shifting a phase of said counter-running guided modes within the cavity to alter a mode profile to increase a near field intensity of said output signal, wherein said alternating grating elements (138, 140) having a lower gain value have a characteristic that sufficient photo-excited carrier generation occurs as an applied gain increases to compensate for carrier depletion in the active layer, to ameliorate spatial hole burning.

4. A surface emitting semiconductor laser as claimed in Claim 1, 2 or 3 wherein said means (26, 141) for phase shifting comprises a modulated pitch formed in said grating (24, 125).

5. A surface emitting semiconductor laser as claimed in Claim 4 wherein, in use of said laser, said modulated pitch grating (24, 125) generates a generally Gaussian shaped surface emission profile.

6. A surface emitting semiconductor laser as claimed in Claim 4 or 5 wherein, in use of said laser, said modulated pitch grating (24, 125) causes one or more secondary modes to have surface emissions approaching zero at a centre of said laser structure.

7. A surface emitting semiconductor laser as claimed in any one of the preceding Claims wherein, in use of said laser, said semiconductor laser structure (10, 100) emits a second output signal in the form of an edge emission in addition to the signal emitted as a surface emission.

8. A surface emitting semiconductor laser as claimed in any one of the preceding Claims wherein the structure further includes an adjoining region at least partially surrounding the grating in plan view, the adjoining region being formed of a material having a resistance sufficient to electrically isolate said grating, when the laser is in use.

9. A surface emitting semiconductor laser according to claim 8 as dependant directly or indirectly on claim 1 wherein said adjoining region further includes integrally formed absorbing regions located at either end of said gain coupled grating.

10. A surface emitting semiconductor laser according to claim 8 having a photo-detector (200), the laser further including a feedback connected to said photo-detector to compare a detected output signal with a desired output signal and an adjuster for adjusting an input current to maintain said output signal at a desired characteristic.

11. An array of surface emitting semiconductor lasers as claimed in any one of the preceding Claims wherein said array includes two or more of said lasers (10) on a common substrate (400).

12. A method of fabricating surface emitting semiconductor lasers, said method comprising the steps of forming a plurality of semiconductor laser structures by forming, in successive layers on a common wafer substrate; a first cladding layer, an active layer and a second cladding layer on said wafer substrate; forming a plurality of second order gratings associated with said active layer on said water substrate, with alternating grating elements of larger and smaller gain values wherein a refractive index of said larger gain value elements decreases as more gain is applied to ameliorate spatial hole burning; forming a phase shifter in said grating to alter a mode profile of an output signal from said semiconductor laser; forming electrodes on each of said semiconductor laser structures on said wafer substrate for injecting current into each of said gratings; and testing each of said semiconductor laser structures by injecting a testing current into said structures while the same are still connected to said common wafer substrate.

## Patentansprüche

1. Oberflächenemittierender Halbleiterlaser mit einer Halbleiterlaserstruktur (10), die eine aktive Schicht (22), gegenüberliegende Cladding-Schichten (20, 34) angrenzend an genannte aktive Schicht, ein Substrat und Elektroden (12, 14) aufweist, durch die Strom in die Halbleiterlaserstruktur injiziert werden kann, damit genannte Laserstruktur ein Ausgabesignal in Form von zumindest einer Oberflächenemission emittiert, **dadurch gekennzeichnet, daß** ein verstärkungsgekoppeltes Gitter zweiter Ordnung (24) genannter aktiver Schicht (22) genannter Laserstruktur zugeordnet ist, wobei genanntes verstärkungsgekoppeltes Gitter eine Vielzahl von Gitterelementen (27, 28) aufweist, die periodisch alternierende größere und kleinere Verstärkungswerte aufweisen, wenn genannter Strom in genannte Laserstruktur injiziert wird, wobei genanntes Gitter dimensioniert und gestaltet ist, um gegenläufige geführte Moden im Resonator zu erzeugen, und Einrichtungen (26) zum Verschieben einer Phase von genannten gegenläufigen geführten Moden im Resonator vorgesehen sind, um ein Modenprofil zu ändern und die Nahfeldintensität von genanntem Ausgabesignal zu erhöhen, wobei genannte alternierende Gitterelemente (27, 28) mit einem größeren Verstärkungswert einen Brechungsindex aufweisen, der abnimmt, wenn mehr Verstärkung angewandt wird, um räumliches Lochbrennen zu bessern.

2. Oberflächenemittierender Halbleiterlaser nach Anspruch 1, **dadurch gekennzeichnet, daß** genanntes verstärkungsgekoppelte Beugungsgitter (24) optisch aktiv ist und in einem Verstärkungsmedium in der aktiven Schicht (22) ausgebildet ist.

3. Oberflächenemittierender Halbleiterlaser mit einer Halbleiterlaserstruktur (100), die eine aktive Schicht (122), gegenüberliegende Cladding-Schichten (120, 126) angrenzend genannte aktive Schicht, ein Substrat und Elektroden (112, 114) aufweist, mittels derer Strom in genannte Halbleiterlaserstruktur injiziert werden kann, damit genannte Laserstruktur ein Ausgabesignal in Form von zumindest einer Oberflächenemission emittiert, **dadurch gekennzeichnet, daß** ein verlustgekoppeltes Gitter (125) zweiter Ordnung genannter aktiver Schicht genannter Laserstruktur zugeordnet ist, wobei genanntes verlustgekoppeltes Gitter eine Vielzahl von Gitterelementen (138, 140) aufweist, die periodisch alternierende größere und kleinere Verstärkungswerte aufweisen, wenn genannter Strom in genannte Laserstruktur injiziert wird, wobei genanntes Gitter dimensioniert und gestaltet ist, um gegenläufige geführte Moden im Resonator zu erzeugen; und Einrichtungen (141) zum Verschieben einer Phase von genannten gegenläufigen geführten Moden im Resonator vorgesehen sind, um ein Modenprofil zu ändern und eine Nahfeldintensität von genanntem Ausgabesignal zu erhöhen, wobei genannte alternierende Gitterelemente (138, 140) mit einem niedrigeren Verstärkungswert eine Eigenschaft aufweisen, daß ausreichende lichtangeregte Trägererzeugung erfolgt, wenn eine angewandte Verstärkung zunimmt, um Trägerverarmung in der aktiven Schicht zu kompensieren und räumliches Lochbrennen zu bessern.

4. Oberflächenemittierender Halbleiterlaser nach Anspruch 1, 2 oder 3, **dadurch gekennzeichnet, daß** genannte Einrichtung (26, 141) zur Phasenverschiebung ein in genanntem Gitter (24, 125) ausgebildetes moduliertes Grundmaß aufweist.

5. Oberflächenemittierender Halbleiterlaser nach Anspruch 4, **dadurch gekennzeichnet, daß** im Gebrauch von genanntem Laser genanntes Gitter (24, 125) mit moduliertem Grundmaß ein allgemein Gauß-förmiges Oberflächenemissionsprofil erzeugt.

6. Oberflächenemittierender Halbleiterlaser nach Anspruch 4 oder 5, **dadurch gekennzeichnet, daß** im Gebrauch von genanntem Laser genanntes Gitter (24, 125) mit moduliertem Grundmaß eine oder mehrere sekundäre Mode(n) Oberflächenemissionen haben läßt, die sich in der Mitte von genannter Laserstruktur Null nähern.

7. Oberflächenemittierender Halbleiterlaser nach einem der vorangehenden Ansprüche, **dadurch gekennzeichnet, daß** im Gebrauch von genanntem Laser genannte Halbleiterlaserstruktur (10, 100) ein zweites Ausgabesignal in Form einer Kantenemission zusätzlich zum als eine Oberflächenemission emittierten Signal emittiert.

8. Oberflächenemittierender Halbleiterlaser nach einem der vorangehenden Ansprüche, **dadurch gekennzeichnet, daß** die Struktur ferner ein angrenzendes Gebiet enthält, das das Gitter in Draufsicht zumindest teilweise umgibt, wobei das angrenzende Gebiet aus einem Material mit einem Widerstand gebildet ist, der zum elektrischen Isolieren von genanntem Gitter ausreicht, wenn der Laser benutzt wird.

9. Oberflächenemittierender Halbleiterlaser nach Anspruch 8 direkt oder indirekt abhängig von Anspruch 1, **dadurch gekennzeichnet, daß** genanntes angrenzendes Gebiet außerdem einteilig ausgebildete absorbierende Gebiete enthält, die an jedem Ende von genanntem verstärkungsgekoppelten Gitter angeordnet sind.

10. Oberflächenemittierender Halbleiterlaser nach Anspruch 8 mit einem Photodetektor (200),
wobei der Laser außerdem eine Rückkopplung, die mit genanntem Photodetektor verbunden ist, um ein detektiertes Ausgabesignal mit einem gewünschten Ausgabesignal zu vergleichen, und eine Einstelleinrichtung zur Einstellung eines Eingabestroms zur Aufrechterhaltung von genanntem Ausgabesignal mit einer gewünschten Eigenschaft enthält.

11. Anordnung von oberflächenemittierenden Halbleiterlasern nach einem der vorangehenden Ansprüche, **dadurch gekennzeichnet, daß** genannte Anordnung zwei oder mehr von genannten Lasern (10) auf einem gemeinsamen Substrat (400) enthält.

12. Verfahren zur Herstellung von oberflächenemittierenden Halbleiterlasern, wobei genanntes Verfahren die Schritte umfaßt: Ausbilden einer Vielzahl von Halbleiterlaserstrukturen durch Ausbilden, in aufeinanderfolgenden Schichten auf einem gemeinsamen Wafersubstrat, von einer ersten Cladding-Schicht, einer aktiven Schicht und einer zweiten Cladding-Schicht auf genanntem Wafersubstrat; Ausbilden einer Vielzahl von genannter aktiver Schicht auf genanntem Wafersubstrat zugeordneten Gittern zweiter Ordnung mit alternierenden Gitterelementen mit größeren und kleineren Verstärkungswerten, wobei der Brechungsindex von genannten Elementen mit größerem Verstärkungswert abnimmt, wenn mehr Verstärkung angewendet wird, um räumliches Lochbrennen zu bessern; Ausbilden einer Phasenverschiebeeinrichtung in genanntem Gitter zur Änderung eines Modenprofils eines Ausgabesignals von genanntem Halbleiterlaser; Ausbilden von Elektroden auf jeder genannter Halbleiterlaserstrukturen auf genanntem Wafersubstrat zum Injizieren von Strom in jedes genannte Gitter; und Testen von jeder genannter Halbleiterlaserstrukturen durch Injizieren eines Teststroms in genannte Strukturen, während dieselben weiterhin mit genanntem gemeinsamem Wafersubstrat verbunden sind.

## Revendications

1. Laser à semi-conducteur à émission par la surface comportant une structure de laser à semi-conducteur (10) ayant une couche active (22), des couches de revêtement opposées (20, 34) contiguës à ladite couche active, un substrat et des électrodes (12, 14) par lesquelles un courant peut être injecté dans ladite structure laser à semi-conducteur pour faire émettre par ladite structure laser un signal de sortie sous la forme d'au moins une émission par la surface, **caractérisé en ce qu'**un réseau couplé à gain du deuxième ordre (24) est associé à ladite couche active (22) de ladite structure laser, ledit réseau couplé à gain ayant une pluralité d'éléments de réseau (27, 28) ayant des valeurs de gain plus grande et plus petite alternées périodiquement lorsque ledit courant est injecté dans ladite structure laser, ledit réseau ayant une taille et une forme permettant de générer des modes guidés se propageant en sens contraire dans la cavité, et des moyens (26) sont prévus pour déplacer une phase desdits modes guidés se propageant en sens contraire dans la cavité pour modifier un profil de mode afin d'augmenter une intensité en champ proche dudit signal de sortie, dans lequel lesdits éléments de réseau alternés (27, 28) ayant une valeur de gain plus grande ont un indice de réfraction qui diminue à mesure qu'un gain plus grand est appliqué pour améliorer la cuisson spatiale des trous.

2. Laser à semi-conducteur à émission par la surface selon la revendication 1, dans lequel ledit réseau de diffraction couplé à gain (24) est optiquement actif et est formé dans un milieu de gain dans la couche active (22).

3. Laser à semi-conducteur à émission par la surface comportant une structure de laser à semi-conducteur (100) ayant une couche active (122), des couches de revêtement opposées (120, 126) contiguës à ladite couche active, un substrat et des électrodes (112, 114) par lesquelles un courant peut être injecté dans ladite structure laser à semi-conducteur pour faire émettre par ladite structure laser un signal de sortie sous la forme d'au moins une émission par la surface, **caractérisé en ce qu'**un réseau couplé à perte du deuxième ordre (125) est associé à ladite couche active de ladite structure laser, ledit réseau couplé à perte ayant une pluralité d'éléments de réseau (138, 140) ayant des valeurs de gain plus grande et plus petite alternées périodiquement lorsque ledit courant est injecté dans ladite structure laser, ledit réseau ayant une taille et une forme permettant de générer des modes guidés se propageant en sens contraire dans la cavité ; et des moyens (141) sont prévus pour déplacer une phase desdits modes guidés se propageant en sens contraire dans la cavité pour modifier un profil de mode afin d'augmenter une intensité en champ proche dudit signal de sortie, dans lequel lesdits éléments de réseau alternés (138, 140) ayant une valeur de gain plus petite ont une caractéristique selon laquelle une génération suffisante de porteurs photo-excités se produit à mesure qu'un gain appliqué augmente pour compenser l'appauvrissement des porteurs dans la couche active, pour améliorer la cuisson spatiale des trous.

4. Laser à semi-conducteur à émission par la surface selon la revendication 1, 2 ou 3, dans lequel lesdits moyens (26, 141) pour déplacer la phase comprennent un pas modulé formé dans ledit réseau (24, 125).

5. Laser à semi-conducteur à émission par la surface selon la revendication 4, dans lequel, dans l'utilisation dudit laser, ledit réseau à pas modulé (24, 125) génère un profil d'émission par la surface de forme généralement Gaussienne.

6. Laser à semi-conducteur à émission par la surface selon la revendication 4 ou 5, dans lequel, dans l'utilisation dudit laser, ledit réseau à pas modulé (24, 125) donne à un ou plusieurs modes secondaires des émissions par la surface approchant zéro au centre de ladite structure laser.

7. Laser à semi-conducteur à émission par la surface selon l'une quelconque des revendications précédentes, dans lequel, dans l'utilisation dudit laser, ladite structure laser à semi-conducteur (10, 100) émet un deuxième signal de sortie sous la forme d'une émission latérale en plus du signal émis comme une émission par la surface.

8. Laser à semi-conducteur à émission par la surface selon l'une quelconque des revendications précédentes, dans lequel la structure inclut en outre une région contiguë entourant au moins partiellement le réseau en vue en plan, la région contiguë étant formée d'un matériau ayant une résistance suffisante pour isoler électriquement ledit réseau, lorsque le laser est utilisé.

9. Laser à semi-conducteur à émission par la surface selon la revendication 8 dépendant directement ou indirectement de la revendication 1, dans lequel ladite région contiguë inclut en outre des régions absorbantes formées solidaires situées au niveau de chaque extrémité dudit réseau couplé à gain.

10. Laser à semi-conducteur à émission par la surface selon la revendication 8 ayant un photodétecteur (200), le laser incluant en outre une rétroaction connectée audit photodétecteur pour comparer un signal de sortie détecté avec un signal de sortie souhaité et un dispositif de réglage pour régler un courant d'entrée afin de maintenir ledit signal de sortie à une caractéristique souhaitée.

11. Matrice de lasers à semi-conducteur à émission par la surface selon l'une quelconque des revendications précédentes, dans laquelle ladite matrice inclut deux ou plus desdits lasers (10) sur un substrat commun (400).

12. Procédé de fabrication de lasers à semi-conducteur à émission par la surface, ledit procédé comprenant les étapes consistant à former une pluralité de structures lasers à semi-conducteur en formant, dans des couches successives sur un substrat en tranche commun ; une première couche de revêtement, une couche active et une deuxième couche de revêtement sur ledit substrat en tranche ; former une pluralité de réseaux du deuxième ordre associés à ladite couche active sur ledit substrat en tranche, avec des éléments de réseaux alternés de valeurs de gain plus grande et plus petite, dans lequel un indice de réfraction desdits éléments de valeur de gain plus grande diminue à mesure qu'un gain plus grand est appliqué pour améliorer la cuisson spatiale des trous ; former un déphaseur dans ledit réseau pour modifier un profil de mode d'un signal de sortie à partir dudit laser à semi-conducteur ; former des électrodes sur chacune desdites structures lasers à semi-conducteur sur ledit substrat en tranche pour injecter un courant dans chacun desdits réseaux ; et tester chacune desdites structures lasers à semi-conducteur en injectant un courant de test dans lesdites structures lorsque celles-ci sont connectées audit substrat en tranche commun.
